# EUROPEAN PATENT SPECIFICATION

(11) **EP 3 667 338 B1**
(45) Date of publication and mention of the grant of the patent: **18.08.2021**
(21) Application number: 18211736.6
(22) Date of filing: 11.12.2018
(51) Int. Cl.: G01R 31/52

(54) **SWITCHGEAR LEAKAGE CURRENT MONITORING SYSTEM FOR A HIGH VOLTAGE OR MEDIUM VOLTAGE SWITCHGEAR**
SCHALTANLAGENLECKSTROMÜBERWACHUNGSSYSTEM FÜR EINE HOCH- ODER MITTELSPANNUNGSSCHALTANLAGE
SYSTÈME DE SURVEILLANCE DU COURANT DE FUITE D'UN APPAREILLAGE DE COMMUTATION HAUTE TENSION OU MOYENNE TENSION

(43) Date of publication of application: 17.06.2020
(60) Divisional application: 21183309.0
(73) Proprietor: ABB Schweiz AG, 5400 Baden (CH)
(72) Inventor: Disselnkötter, Rolf, 69256 Mauer (DE); Stefanka, Martin, 664 61 Rajhrad (CZ)
(74) Representative: Maiwald Patent- und Rechtsanwaltsgesellschaft mbH

(56) References cited:
- JP-B2- 3 757 508
- US-A- 5 640 154
- US-A1- 2017 146 588
- US-B1- 6 633 169
- KLOS H-J ET AL: "Experience with aging and humidity tests according to IEC Report 932", ELECTRICAL INSULATION AND DIELECTRIC PHENOMENA, 1995. ANNUAL REPORT., CONFERENCE ON VIRGINIA BEACH, VA, USA 22-25 OCT. 1, NEW YORK, NY, USA,IEEE, US, 22 October 1995 (1995-10-22), pages 282-285, XP010155047, DOI: 10.1109/CEIDP.1995.483718 ISBN: 978-0-7803-2931-7

## Description

### FIELD OF THE INVENTION

The present invention relates to a switchgear leakage current monitoring system for a high voltage or medium voltage switchgear.

### BACKGROUND OF THE INVENTION

A High voltage or medium voltage switchgear that is exposed to air, can suffer from a deposition of dust and suffer from the effects of humidity on the surface of its insulating components. This holds both for air insulated HV-switchgear and (depending on the environment and the climatic zone of the installation) and also for components in MV-switchgear cabinets, which cannot be completely sealed off from the environment.

The deposition of dust and the effects of humidity on the surface of electrically stressed insulating components can lead to an increased surface conductivity on these insulators. This can give rise to leakage currents and dry-band arcing. Both the leakage currents (which may typically reach levels of 5 - 100mA on insulating components in MV-installations) and the arcing will cause a progressive degradation and carbonization of the insulator surfaces through thermal effects, which will be indicated by accelerated surface tracking. This will further increase the surface conductivity and the amplitude of the leakage currents and will finally lead to a catastrophic failure (short circuit across the component) and an outage of the switchgear section/cubicle, if no timely action is taken to prevent the progressive destruction.

A continuous monitoring of the switchgear leakage currents would enable the generation of early warnings and allow the execution of a predictive maintenance strategy. However, an overall differential leakage current measurement (e.g. per cubicle) is not straight-forward, for a number of reasons:
- differential leakage current sensors enclosing the conductors of all of the concerned phases (e.g. the bus bars in a MV-switchgear system) would need to be large and would be costly;
- leakage current measurement based on a measurement of the individual phase currents would require very accurate and costly current sensors;
- there may be downstream leakage currents, which will impede the localization of the failures. Failure localization would require at least two very precise and costly differential current sensors;
- there may be loads like voltage transformers or voltage sensors, that allow the flow of currents between a phase and ground leading to a differential current that cannot be distinguished from a leakage current by a sensor measuring the overall differential current; and
- depending on the network grounding scheme and parasitic capacitances there may be additional phase-to-ground currents, which are not related to insulation failures.

Furthermore, a direct measurement of leakage currents in the grounding system is mostly infeasible. This is because:
- there are typically many connection points to and within the grounding system. A complete encirclement of the currents by means of a current sensor is usually not possible; and
- leakage currents will spread out in the grounding system, leading to very small current densities and local magnetic field amplitudes, which are moreover typically much lower than the field amplitudes generated by the phase currents themselves. The measurement of the currents by means of magnetic field sensors is therefore not possible.

Consequently, leakage currents are usually not yet monitored in MV and HV switchgear systems, as a precise measurement would require high installation effort and cost.

Leakage current sensors for MV/HV systems are known from US2017/146588, US6633169, US5640154, JP3757508; and from the IEEE paper 'Experience with aging and humidity tests according to IEC Report 932, by Klos et al, ELECTRICAL INSULATION AND DIELECTRIC PHENOMENA, 1995. ANNUAL REPORT., CONFERENCE ON VIRGINIA BEACH, VA, USA 22-25 OCT. 1, NEW YORK, NY, USA,IEEE, US, 22 October 1995, pages 282-285.

There is a need to find an efficient means of monitoring leakage currents in high voltage and medium voltage switchgear.

### SUMMARY OF THE INVENTION

Therefore, it would be advantageous to have an improved leakage current monitoring system for a high voltage or medium voltage switchgear.

The object of the present invention is solved with the subject matter of the independent claims, wherein further embodiments are incorporated in the dependent claims.

In a first aspect, there is provided a switchgear leakage current monitoring system for a high voltage or medium voltage switchgear, comprising:
- at least one sensor; and
- a leakage current monitoring unit.

The at least one sensor comprises at least one conducting layer or electrode. Each sensor comprises a conducting layer or electrode. The at least one conducting layer or electrode is attached or integrated on at least one surface of at least one insulating component of a high voltage or medium voltage switchgear. Each insulating component has a conducting layer or electrode attached or integrated on its surface. The at least one sensor is configured to acquire at least one leakage current signal. Each sensor is configured to acquire a leakage current signal on a surface of the insulating component to which its corresponding conducting layer or electrode is attached or integrated. The at least sensor has at least one data connection to the leakage current monitoring unit. The leakage current monitoring unit is configured to be provided with at least one measurement data relating to the at least one leakage current signal via the at least one data connection.

In this manner, degradation and carbonization of insulators of high voltage and medium voltage switchgear can be monitored through the detection of leakage currents on the surfaces of those insulators, caused due to increase surface conductivity through for example the deposition of dust and humidity.

Further, the at least one insulating component is mechanically attached to at least one electrically conductive part at ground potential of the high voltage or medium voltage switchgear. Each insulating component is mechanically attached to an electrically conductive part. The at least one conducting layer or electrode is situated at a corresponding at least one location of the at least one insulating component that is close to the at least one electrically conductive part such that the at least one conducting layer or electrode is not in direct contact with the at least one electrically conductive part.
In other words, the leakage current detection parts of sensors are close to, but not in direct contact with electrically conductive parts of the switchgear to which the insulators are mounted. Further, the at least one sensor comprises at least one ground connection In this manner, a ground potential reference can be provided to the measurement circuit.

In an example, the at least one sensor comprises at least one connection connected to the at least one conducting layer or electrode. The at least one connection is close to the at least one electrically conductive part such that the at least one connection is not in direct contact with the at least one electrically conductive part.
By having the conducting layer or electrode of the sensor and the associated connection close to the conductor at ground potential means that creeping distances on the surface of the insulator are not significantly reduced.

In an example, a connection to a conducting layer or electrode and a ground connection of a sensor are located close to one another.
In this manner, large ground loops can be avoided.

In an example, a conducting layer or electrode of the at least one conducting layer or electrode is mechanically attached to an electrically conductive part of the at least one electrically conductive part to which a corresponding insulating component is mechanically attached. The conducting layer or electrode is isolated from the electrically conductive part by an insulating layer.
In this manner, a reduction of surface creeping distances on the insulating component can be completely avoided.

In an example, the insulating layer is attached to the conducting layer or electrode.

In an example, the insulating layer is attached to the electrically conductive part at ground potential.

In an example, each conducting layer or electrode of the at least one conducting layer or electrode encircles the insulating component of the at least one insulating component to which it is attached or integrated.
In this way, the leakage current can be detected to the greatest extent.

In an example, a conducting layer or electrode of the at least one conducting layer or electrode is integrated into a printed circuit board.

In an example, a conducting layer or electrode of the at least one conducting layer or electrode is a metallic sheet, or glued foil, or wire.

In an example the at least one insulating component comprises one or more of: bushings; post insulators, insulation of contact plugs, insulating case of current transducer, insulating case of voltage transducers.

In an example, the at least one data connection comprises at least one wired connection. A measurement circuit integrated into the leakage current monitoring unit comprises a low impedance shunt and a voltage meter.

In an example, the at least one data connection comprises at least one wireless connection. A measurement unit is configured to provide one or more measurement data relating to the at least one leakage current wirelessly to the leakage current monitoring unit. The measurement unit is configured to be powered by leakage current it measures.

The above aspect and examples will become apparent from and be elucidated with reference to the embodiments described hereinafter.

### BRIEF DESCRIPTION OF THE DRAWINGS

Exemplary embodiments will be described in the following with reference to the following drawings:
Fig. 1 shows an example of a switchgear leakage current monitoring system;
Fig. 2 shows an example of a leakage current source (equivalent circuit);
Fig. 3 shows an example of a post insulator;
Fig. 4 shows an example of a ring type current sensor;
Fig. 5 shows an example of a block type current or combi-sensor;
Fig. 6 shows an example of a bushing;
Fig. 7 shows an example of a contact plug;
Fig. 8 shows an example of a wired connection of measurement points; and
Fig. 9 shows an example of wireless connection of measurement points.

### DETAILED DESCRIPTION OF EMBODIMENTS

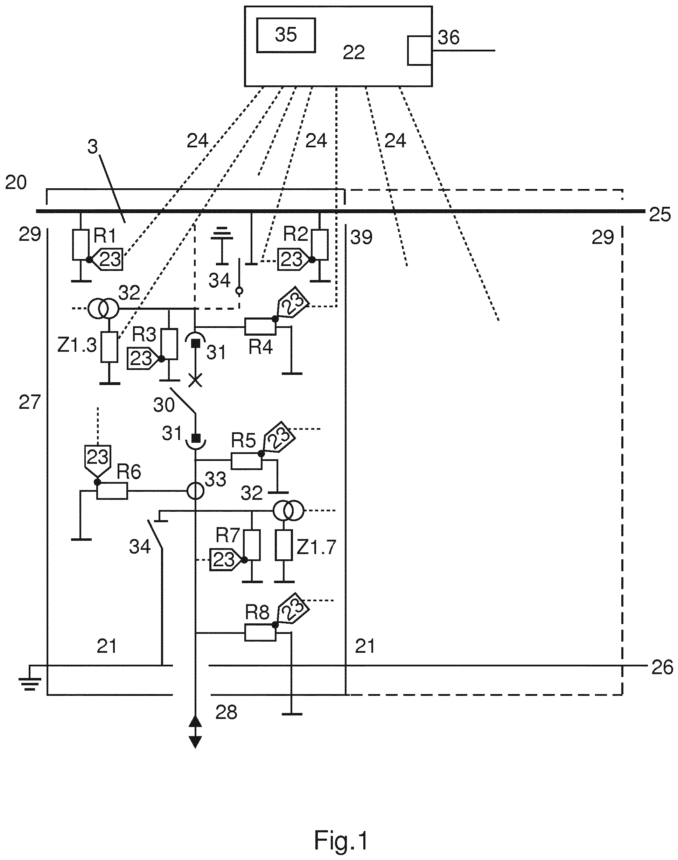

Figs. 1-9 show detailed examples of a switchgear leakage current monitoring system 1 for a high voltage or medium voltage switchgear.
The figures show examples of a switchgear leakage current monitoring system 1 for a high voltage or medium voltage switchgear. The switchgear leakage current monitoring system comprises at least one sensor 14, 16, 17, and a leakage current monitoring unit 22. The at least one sensor comprises at least one conducting layer or electrode 14. Each sensor comprises a conducting layer or electrode. The at least one conducting layer or electrode is attached or integrated on at least one surface of at least one insulating component 11 of a high voltage or medium voltage switchgear. Each insulating component has a conducting layer or electrode attached or integrated on its surface. The at least one sensor is configured to acquire at least one leakage current signal. Each sensor is configured to acquire a leakage current signal on a surface of the insulating component to which its corresponding conducting layer or electrode is attached or integrated. The at least sensor has at least one data connection 24 to the leakage current monitoring unit. The leakage current monitoring unit is configured to be provided with at least one measurement data relating to the at least one leakage current signal via the at least one data connection.

According to an example, the at least one insulating component is mechanically attached to at least one electrically conductive part 12 at ground potential of the high voltage or medium voltage switchgear. Each insulating component is mechanically attached to an electrically conductive part. The at least one conducting layer or electrode is situated at a corresponding at least one location 23 of the at least one insulating component that is close to the at least one electrically conductive part. This means that the at least one conducting layer or electrode is not in direct contact with the at least one electrically conductive part.

According to an example, the at least one sensor comprises at least one connection 17 connected to the at least one conducting layer or electrode 14. The at least one connection is close to the at least one electrically conductive part such that the at least one connection is not in direct contact with the at least one electrically conductive part.

According to an example, the at least one sensor comprises at least one ground connection 16.

In an example, a ground connection 16 of a sensor associated with an insulating component 11 is connected to the electrically conductive part 12 at ground potential to which the insulating component is mechanically attached.

According to an example, a connection 17 to a conducting layer or electrode 14 and a ground connection 16 of a sensor are located close to one another.

According to an example, a conducting layer or electrode 14 of the at least one conducting layer or electrode 14 is mechanically attached to an electrically conductive part 12 of the at least one electrically conductive part 12 to which a corresponding insulating component 11 is mechanically attached. The conducting layer or electrode 14 is isolated from the electrically conductive part by an insulating layer 15.

According to an example, the insulating layer 15 is attached to the conducting layer or electrode 14.

According to an example, the insulating layer 15 is attached to the electrically conductive part 12 at ground potential.

According to an example, each conducting layer or electrode of the at least one conducting layer or electrode 14 encircles the insulating component of the at least one insulating component 11 to which it is attached or integrated.

According to an example, a conducting layer or electrode of the at least one conducting layer or electrode 14 is integrated into a printed circuit board 19.

According to an example, a conducting layer or electrode of the at least one conducting layer or electrode 14 is a metallic sheet, or glued foil, or wire.

According to an example, the at least one insulating component 11 comprises one or more of: bushings 29, post insulators, insulation of contact plugs 31, insulating case of current transducer 33, and insulating case of voltage transducers 32.

According to an example, the at least one data connection 24 comprises at least one wired connection 24.1. A measurement circuit 40 integrated into the leakage current monitoring unit 22 comprises a low impedance shunt 41 and a voltage meter 43.

According to an example, the at least one data connection 24 comprises at least one wireless connection 24.2. A measurement unit 44 is configured to provide one or more measurement data relating to the at least one leakage current wirelessly to the leakage current monitoring unit 22. The measurement unit 44 is configured to be powered by leakage current it measures.

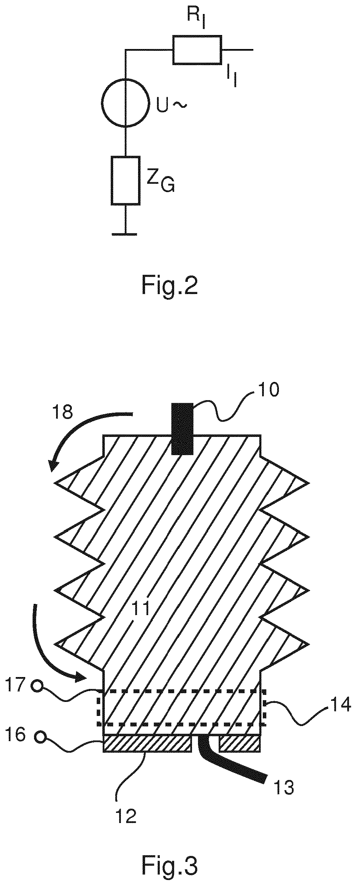

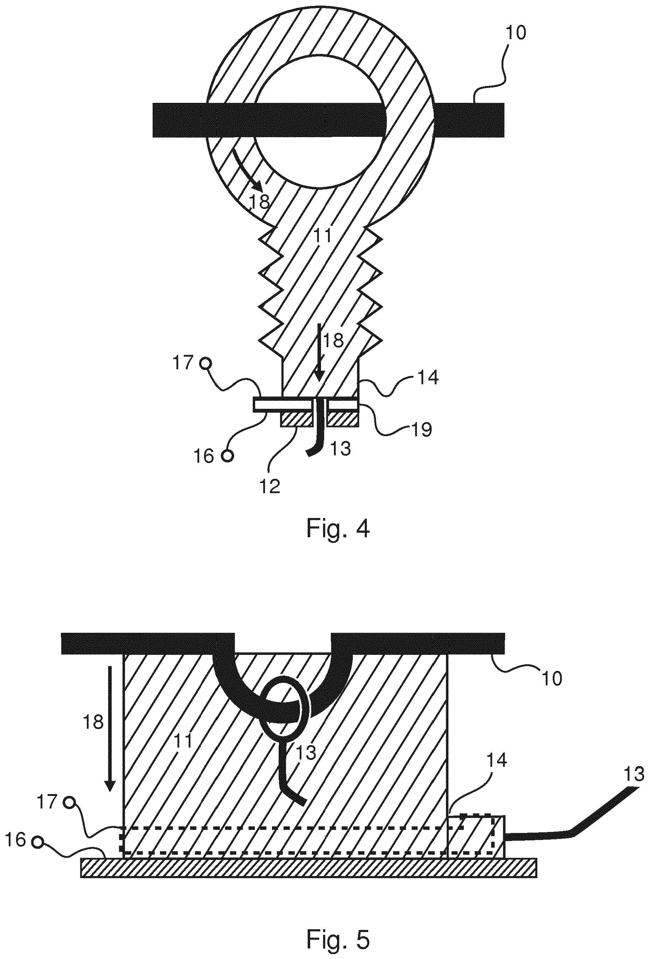

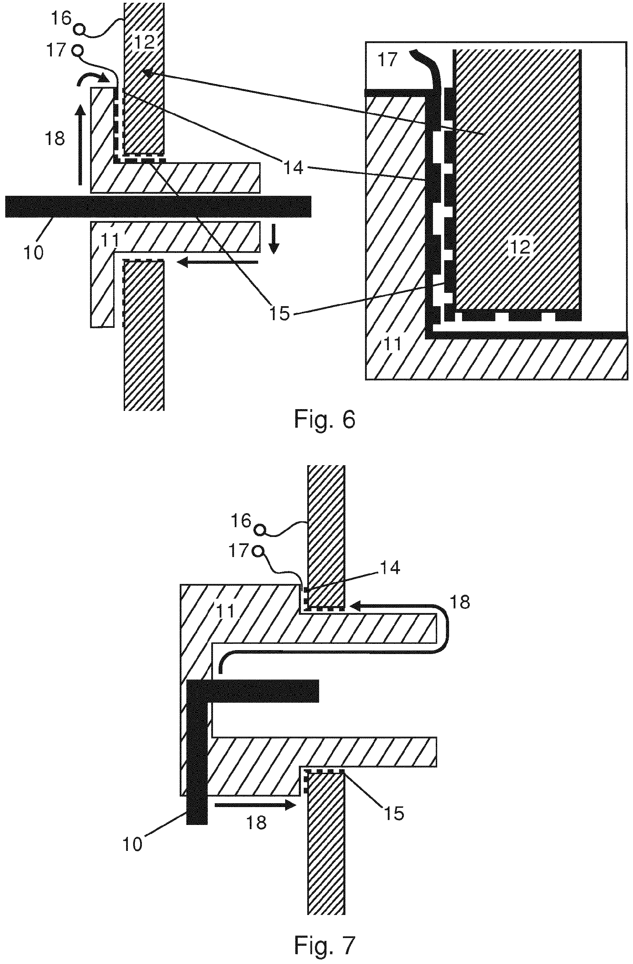

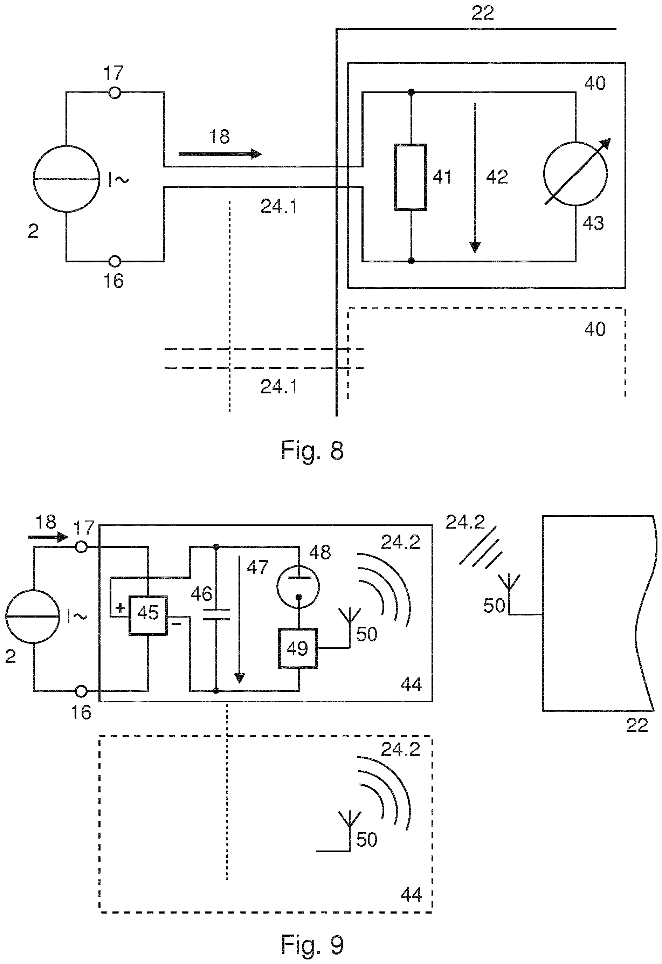

The switchgear leakage current monitoring system enables the local leakage currents on the surface of the individual insulating components 11 to be continuously monitored. This is now described in further detail using the example of medium voltage switchgear and with reference to Figs. 1-9.
The switchgear leakage current monitoring system 1 includes a central unit 22, which records a number of insulator leakage currents from one or more cubicles/sections 21 of the switchgear 20. It will transmit either the raw or processed data of the recorded leakage currents via a suitable interface and data connection 36 to a superordinate system, which will process and/or store the data for further analysis. The central unit 22 can also include a local indication of the leakage currents or of possible critical conditions (through for example an optical display 35 or acoustic signal).
In addition, the central unit 22 can also perform a local analysis on the acquired leakage current signals. For example: a comparison with critical amplitudes or reference signals; a frequency analysis with an identification of critical frequency components; or the time-development of the leakage current amplitudes.
Based on the signal analysis of either the central unit 22 or the superordinate system, one or both of them will indicate the leakage current status of the supervised part of the switchgear, and indicate critical conditions or trends with an alarm and identify affected components. Furthermore, the system may generate model-based information on the remaining component lifetimes and on the urgency and amount of required maintenance measures, such as surface cleaning or the necessary exchange of components, before any catastrophic failures will occur.
The central unit 22 has data connections 24 to a number of measurement locations 23 that are situated on the surfaces of those insulating components 11 that shall be monitored. The measurement locations are close to but not in direct contact with electrically conducting parts 12 on ground potential, to which the insulators 11 are mechanically attached (for example, cubicle walls or mounting surfaces).
The data connections 24 can be either based on wired (cable) connections or on any known or new wireless communication scheme.
Examples of insulating components 11 in the switchgear, on which surface leakage currents could be monitored, include bushings 29, as shown in Fig. 6, post insulators as shown in Fig. 3, the insulation of contact plugs 31, as shown in Fig. 7, as well as the insulating cases of current transducers/transformers 33 and voltage transducers/transformers 32 as shown in Figs. 4-5.
Fig. 1 shows where the respective leakage impedances R1 ... R8 would be typically located within a MV switchgear cubicle, and where suitable measurement locations 23 would be preferably established.
When the leakage currents are not yet too large, they can be assumed to originate from ideal current sources (see Fig. 2), as the involved surface impedances are high. Therefore, the leakage current amplitudes will be largely independent on the input impedance of a connected measurement circuitry, if the latter is designed to be low enough. It is therefore sufficient, to attach a conducting pickup electrode or layer 14 to the surface of the insulator 11 at the respective measurement location 23, which shall be close to but not in direct electrical contact with conducting parts 12 at ground potential, to which the insulator 11 is mechanically attached. Ideally, this pickup electrode or layer 14 should completely encircle the region, where the insulator is in mechanical contact with the conducting part at ground potential in order to collect the injected leakage current to the largest possible extent. The pickup electrode or layer 14 is provided with a connection 17 for contacting to the input of the measurement circuit. Another connection 16 on a conducting part at ground potential 12 provides the reference to the measurement circuit. This connection may either be integrated with the insulating component, or, if no grounded metallic parts are available on this component, it may be integrated with the switchgear cubicle. Connections 16 and 17 are preferably located close to each other in order to avoid large ground loops. Placing electrode or layer 14 and connection 17 close to the conductor at ground potential also has the advantage that creeping distances on the surface of the insulator 11 are not significantly reduced. Examples of suitable configurations can be seen in Figs. 3 and 5. In an alternative design, the conducting pickup electrode or layer 14 is located on the surface area of the insulating component 11, where it is in mechanical contact with the conducting part at ground potential 12. However, the pickup layer or electrode 14 is electrically isolated from part 12 by an additional insulating layer 15, which is on top of layer 14. In this way, a reduction of surface creeping distances on the insulating component 11 can be completely avoided. Examples of such configurations can be seen in Figs. 6 and 7. The stack of layers 14 and 15 can be also implemented as a double-sided printed circuit board 19, which can at the same time integrate connections 16 and 17, when the second copper-layer is put in contact with the conductor at ground potential. An example is shown in Fig. 4.
If the pickup electrode or layer 14 is not integrated on a PCB, it can be realized as a metallic sheet, glued foil or wire, which is closely attached to the insulating body (e.g. during the casting process of the insulating component) in order to prevent leakage currents from bypassing underneath the metal. As an alternative, the electrode or layer can also consist of a conductive coating, like a metal or carbon filled resin, plastic or rubber, which could be spayed or printed onto the insulator surface.
In the case of a wired connection 24.1 (as shown in Fig. 8) between a measurement location 23 and the central unit 22, the respective measurement circuit 40 can be integrated into the central unit. In this case the measurement circuit could be just composed of a low impedance shunt 41 and a voltage meter 43, which measures the voltage drop 42, that is caused across it by the leakage current 18. The current amplitude will be nearly independent of the shunt value, which can be adjusted to obtain a convenient voltage amplitude. This allows an accurate measurement of the leakage current. If an isolated measurement is required, voltage isolation can be provided by additional means like transformers or other common components.
In the case of a wireless connection 24.2, (as shown in Fig. 9) between a measurement location 23 and the central unit 22, the measurement unit 44 will be preferably close to the insulating element. It may be even integrated with the device, e.g. mounted on its surface or molded into the insulating body. The advantage of such a configuration is that there are no cable connections to the central unit 22, which will reduce cost and installation work and increase the reliability of the system. These advantages will be even more significant, if the measurement unit 44 is self-supplied and does not need any batteries to power the electronics. Fig. 9 shows one possible example of such a solution. In this case, the leakage current will be rectified by a rectifier 45, and the rectified current will charge a capacitor 46. If the capacitor voltage 47 reaches a certain level, a discharge element 48 will suddenly become conductive and discharge the capacitor by delivering a current pulse to a wireless transmission unit 49. The discharge element can be a component or an electric circuit that exhibits a negative differential resistance above the said voltage level, like a reversely biased diode, a negative-glow lamp, etc. When the transmission unit is supplied by the current pulse, it will transmit its address (identifier) in a short wireless telegram to the central unit. The frequency of the telegrams with a specific identifier will thus indicate the amplitude of the respective leakage current. Transmission and receipt is via an appropriate antenna 50.
This however not limited to this simple type of a wireless communication of the leakage current amplitude. The signal can be also digitized with an A/D-converter and transmitted based on a wireless protocol, while the low power electronics of the transmission unit is still powered from the leakage current.

### Reference numerals

- 1: Switchgear leakage current monitoring system
- 10: Mains conductor at medium voltage
- 11: Insulating body
- 12: Grounded metal case or ground plate
- 13: Devices and cables at low voltage
- 14: Conducting layer
- 15: Insulating layer
- 16: Internal ground connection
- 17: Connection to the conducting layer
- 18: Leakage current
- 19: Double sided PCB
- 20: Switch gear
- 21: Switch gear cubicle
- 22: Central leakage current monitoring unit
- 23: Measurement location
- 24: Data connection between a measurement point and the acquisition unit
- 24.1: Wired connection between measurement point and acquisition unit
- 24.2: Wireless connection between measurement point and acquisition unit
- 25: Mains bus bar
- 26: Earthing bus bar
- 27: Cubicle wall
- 28: Outgoing or incoming feeder cable
- 29: Bushing
- 30: Circuit breaker
- 31: Contact plug
- 32: Voltage transformer / voltage sensor
- 33: Current transformer / current sensor
- 34: Grounding switch
- 35: Display
- 36: Interface to superordinate system
- 41: Measurement shunt
- 42: Measurement voltage
- 43: Voltage measuring device
- 44: Wireless measurement unit
- 45: Rectifier
- 46: Storage capacitor
- 47: Capacitor voltage
- 48: Discharge element
- 49: Wireless transmission unit
- 50: Antenna

- R1-R8: Leakage impedances of bushings, plug insulations, sensors, cables
- Z1.3, Z1.7: Primary impedances of voltage transformers / voltage sensors
- U_{∼}: Mains voltage
- Z_{G}: Network grounding impedance
- R_{I}: Leakage impedance
- I_{I},: Leakage current

## Claims

1. A switchgear leakage current monitoring system (1) for a high voltage or medium voltage switchgear, comprising:
- at least one sensor (14, 16, 17); and
- a leakage current monitoring unit (22);
wherein, the at least one sensor comprises at least one conducting layer or electrode (14), wherein each sensor comprises a conducting layer or electrode;
wherein, the at least one conducting layer or electrode is attached or integrated on at least one surface of at least one insulating component (11) of a high voltage or medium voltage switchgear, wherein each insulating component has a conducting layer or electrode attached or integrated on its surface;
wherein, the at least one insulating component is mechanically attached to at least one electrically conductive part (12) at ground potential of the high voltage or medium voltage switchgear, wherein each insulating component is mechanically attached to an electrically conductive part, and wherein the at least one conducting layer or electrode is situated at a corresponding at least one location (23) of the at least one insulating component that is close to the at least one electrically conductive part such that the at least one conducting layer or electrode is not in direct contact with the at least one electrically conductive part;
wherein, the at least one sensor is configured to acquire at least one leakage current signal, wherein each sensor is configured to acquire a leakage current signal on a surface of the insulating component to which its corresponding conducting layer or electrode is attached or integrated;
wherein the at least one sensor comprises at least one ground connection (16);
wherein, the at least sensor has at least one data connection (24) to the leakage current monitoring unit; and
wherein, the leakage current monitoring unit is configured to be provided with at least one measurement data relating to the at least one leakage current signal via the at least one data connection.

2. Switchgear leakage current monitoring system according to claim 1, wherein the at least one sensor comprises at least one connection (17) connected to the at least one conducting layer or electrode, and wherein the at least one connection is close to the at least one electrically conductive part such that the at least one connection is not in direct contact with the at least one electrically conductive part.

3. Switchgear leakage current monitoring system according to claim 1, wherein a connection (17) to a conducting layer or electrode (14) and a ground connection (16) of a sensor are located close to one another.

4. Switchgear leakage current monitoring system according to any of claims 1-3, wherein a conducting layer or electrode (14) of the at least one conducting layer or electrode is mechanically attached to an electrically conductive part (12) of the at least one electrically conductive part to which a corresponding insulating component is mechanically attached, and wherein the conducting layer or electrode is isolated from the electrically conductive part by an insulating layer (15).

5. Switchgear leakage current monitoring system according to claim 4, wherein the insulating layer (15) is attached to the conducting layer or electrode (14).

6. Switchgear eakage current monitoring system according to any of claims 4-5, wherein the insulating layer (15) is attached to the electrically conductive part (12) at ground potential.

7. Switchgear leakage current monitoring system according to any of claims 1-6, wherein each conducting layer or electrode of the at least one conducting layer or electrode (14) encircles the insulating component of the at least one insulating component (11) to which it is attached or integrated.

8. Switchgear leakage current monitoring system according to any of claims 1-7, wherein a conducting layer or electrode of the at least one conducting layer or electrode (14) is integrated into a printed circuit board (19).

9. Switchgear leakage current monitoring system according to any of claims 1-7, wherein a conducting layer or electrode of the at least one conducting layer or electrode (14) is a metallic sheet, or glued foil, or wire.

10. Switchgear leakage current monitoring system according to any of claims 1-9, wherein the at least one insulating component (11) comprises one or more of: bushings (29); post insulators, insulation of contact plugs (31), insulating case of current transducer (33), insulating case of voltage transducers (32).

11. Switchgear leakage current monitoring system according to any of claims 1-10, wherein the at least one data connection comprises at least one wired connection (24.1), and wherein a measurement circuit (40) integrated into the leakage current monitoring unit (22) comprises a low impedance shunt (41) and a voltage meter (43).

12. Switchgear leakage current monitoring system according to any of claims 1-11, wherein the at least one data connection comprises at least one wireless connection (24.2), and wherein a measurement unit (44) is configured to provide one or more measurement data relating to the at least one leakage current wirelessly to the leakage current monitoring unit (22), and wherein the measurement unit is configured to be powered by leakage current it measures.

## Patentansprüche

1. Schaltanlagen-Leckstrom-Überwachungssystem (1) für eine Hochspannungs- oder Mittelspannungs-Schaltanlage, umfassend:
- mindestens einen Sensor (14, 16, 17); und
- eine Leckstromüberwachungseinheit (22);
wobei der mindestens eine Sensor mindestens eine leitende Schicht oder Elektrode (14) umfasst, wobei jeder Sensor eine leitende Schicht oder Elektrode umfasst;
wobei die mindestens eine leitende Schicht oder Elektrode an mindestens einer Oberfläche von mindestens einem isolierenden Bauteil (11) einer Hochspannungs- oder Mittelspannungs-Schaltanlage angebracht oder integriert ist, wobei jedes isolierende Bauteil eine leitende Schicht oder Elektrode an seiner Oberfläche angebracht oder integriert hat;
wobei das mindestens eine isolierende Bauteil mechanisch an mindestens einem elektrisch leitenden Teil (12) auf Erdpotential der Hochspannungs- oder Mittelspannungsschaltanlage befestigt ist, wobei jedes isolierende Bauteil mechanisch an einem elektrisch leitenden Teil befestigt ist, und wobei die mindestens eine leitende Schicht oder Elektrode an einer entsprechenden mindestens einen Stelle (23) des mindestens einen isolierenden Bauteils angeordnet ist, die sich in der Nähe des mindestens einen elektrisch leitenden Teils befindet, so dass die mindestens eine leitende Schicht oder Elektrode nicht in direktem Kontakt mit dem mindestens einen elektrisch leitenden Teil ist;
wobei der mindestens eine Sensor so konfiguriert ist, dass er mindestens ein Leckstromsignal erfasst, wobei jeder Sensor so konfiguriert ist, dass er ein Leckstromsignal an einer Oberfläche des isolierenden Bauteils erfasst, an der seine entsprechende leitende Schicht oder Elektrode angebracht oder integriert ist;
wobei der mindestens eine Sensor mindestens einen Masseanschluss (16) aufweist;
wobei der mindestens eine Sensor mindestens eine Datenverbindung (24) zu der Leckstromüberwachungseinheit aufweist; und
wobei die Leckstromüberwachungseinheit so konfiguriert ist, dass sie über die mindestens eine Datenverbindung mit mindestens einem Messdatenwert versorgt wird, der sich auf das mindestens eine Leckstromsignal bezieht.

2. Schaltanlagen-Leckstrom-Überwachungssystem nach Anspruch 1, wobei der mindestens eine Sensor mindestens einen Anschluss (17) umfasst, der mit der mindestens einen leitenden Schicht oder Elektrode verbunden ist, und wobei der mindestens eine Anschluss nahe an dem mindestens einen elektrisch leitenden Teil liegt, so dass der mindestens eine Anschluss nicht in direktem Kontakt mit dem mindestens einen elektrisch leitenden Teil steht.

3. Schaltanlagen-Leckstrom-Überwachungssystem nach Anspruch 1, wobei ein Anschluss (17) an eine leitende Schicht oder Elektrode (14) und ein Masseanschluss (16) eines Sensors nahe beieinander liegen.

4. Schaltanlagen-Leckstrom-Überwachungssystem nach einem der Ansprüche 1 bis 3, wobei eine leitende Schicht oder Elektrode (14) der mindestens einen leitenden Schicht oder Elektrode mechanisch an einem elektrisch leitenden Teil (12) des mindestens einen elektrisch leitenden Teils befestigt ist, an dem ein entsprechendes isolierendes Bauteil mechanisch befestigt ist, und wobei die leitende Schicht oder Elektrode von dem elektrisch leitenden Teil durch eine Isolierschicht (15) isoliert ist.

5. Schaltanlagen-Leckstrom-Überwachungssystem nach Anspruch 4, wobei die Isolierschicht (15) an der leitenden Schicht oder Elektrode (14) befestigt ist.

6. Schaltanlagen-Leckstrom-Überwachungssystem nach einem der Ansprüche 4-5, wobei die Isolierschicht (15) an dem elektrisch leitfähigen Teil (12) auf Erdpotential befestigt ist.

7. Schaltanlagen-Leckstrom-Überwachungssystem nach einem der Ansprüche 1-6, wobei jede leitende Schicht oder Elektrode der mindestens einen leitenden Schicht oder Elektrode (14) das isolierende Bauteil des mindestens einen isolierenden Bauteils (11), an dem sie befestigt oder integriert ist, umschließt.

8. Schaltanlagen-Leckstrom-Überwachungssystem nach einem der Ansprüche 1-7, wobei eine leitende Schicht oder Elektrode der mindestens einen leitenden Schicht oder Elektrode (14) in eine Leiterplatte (19) integriert ist.

9. Schaltanlagen-Leckstrom-Überwachungssystem nach einem der Ansprüche 1-7, wobei eine leitende Schicht oder Elektrode der mindestens einen leitenden Schicht oder Elektrode (14) ein Metallblech, eine geklebte Folie oder ein Draht ist.

10. Schaltanlagen-Leckstrom-Überwachungssystem nach einem der Ansprüche 1-9, wobei das mindestens eine isolierende Bauteil (11) eine oder mehrere der folgenden Komponenten umfasst: Durchführungen (29); Stützisolatoren, Isolierung von Kontaktsteckern (31), Isoliergehäuse von Stromwandlern (33), Isoliergehäuse von Spannungswandlern (32).

11. Schaltanlagen-Leckstrom-Überwachungssystem nach einem der Ansprüche 1-10, wobei die mindestens eine Datenverbindung mindestens eine drahtgebundene Verbindung (24.1) umfasst und wobei eine in die Leckstromüberwachungseinheit (22) integrierte Messschaltung (40) einen niederohmigen Shunt (41) und einen Spannungsmesser (43) umfasst.

12. Schaltanlagen-Leckstrom-Überwachungssystem nach einem der Ansprüche 1-11, wobei die mindestens eine Datenverbindung mindestens eine drahtlose Verbindung (24.2) umfasst, und wobei eine Messeinheit (44) konfiguriert ist, um eine oder mehrere Messdaten bezüglich des mindestens einen Leckstroms drahtlos an die Leckstromüberwachungseinheit (22) zu liefern, und wobei die Messeinheit konfiguriert ist, um durch den von ihr gemessenen Leckstrom mit Energie versorgt zu werden.

## Revendications

1. Système de surveillance de courant de fuite d'appareillage de commutation (1) pour un appareillage de commutation haute tension ou moyenne tension, comprenant :
- au moins un capteur (14, 16, 17) ; et
- une unité de surveillance de courant de fuite (22) ; dans lequel l'au moins un capteur comprend au moins une couche conductrice ou électrode (14), chaque capteur comprenant une couche conductrice ou électrode ;
dans lequel l'au moins une couche conductrice ou électrode est attachée ou intégrée sur au moins une surface d'au moins un composant isolant (11) d'un appareillage de commutation haute tension ou moyenne tension, chaque composant isolant ayant une couche conductrice ou électrode attachée ou intégrée sur sa surface ;
dans lequel l'au moins un composant isolant est attaché mécaniquement à au moins une pièce électriquement conductrice (12) à un potentiel de terre de l'appareillage de commutation haute tension ou moyenne tension, chaque composant isolant étant attaché mécaniquement à une pièce électriquement conductrice, et l'au moins une couche conductrice ou électrode étant située à au moins un emplacement correspondant (23) de l'au moins un composant isolant qui est proche de l'au moins une pièce électriquement conductrice de telle sorte que l'au moins une couche conductrice ou électrode n'est pas en contact direct avec l'au moins une pièce électriquement conductrice ;
dans lequel l'au moins un capteur est configuré pour acquérir un signal de courant de fuite, chaque capteur étant configuré pour acquérir un signal de courant de fuite sur une surface du composant isolant auquel sa couche conductrice ou électrode correspondante est attachée ou intégrée ;
dans lequel l'au moins un capteur comprend au moins une connexion de terre (16) ;
dans lequel l'au moins un capteur a au moins une connexion de données (24) avec l'unité de surveillance de courant de fuite ; et
dans lequel l'unité de surveillance de courant de fuite est configurée pour recevoir au moins une donnée de mesure relative à l'au moins un signal de courant de fuite par le biais de l'au moins une connexion de données.

2. Système de surveillance de courant de fuite d'appareillage de commutation selon la revendication 1, dans lequel l'au moins un capteur comprend au moins une connexion (17) connectée à l'au moins une couche conductrice ou électrode, et dans lequel l'au moins une connexion est proche de l'au moins une pièce électriquement conductrice de telle sorte que l'au moins une connexion n'est pas en contact direct avec l'au moins une pièce électriquement conductrice.

3. Système de surveillance de courant de fuite d'appareillage de commutation selon la revendication 1, dans lequel une connexion (17) à une couche conductrice ou électrode (14) et une connexion de terre (16) d'un capteur sont situées l'une près de l'autre.

4. Système de surveillance de courant de fuite d'appareillage de commutation selon l'une quelconque des revendications 1 à 3, dans lequel une couche conductrice ou électrode (14) parmi l'au moins une couche conductrice ou électrode est attachée mécaniquement à une pièce électriquement conductrice (12) parmi l'au moins une pièce électriquement conductrice à laquelle un composant isolant correspondant est attaché mécaniquement, et dans lequel la couche conductrice ou électrode est isolée de la pièce électriquement conductrice par une couche isolante (15).

5. Système de surveillance de courant de fuite d'appareillage de commutation selon la revendication 4, dans lequel la couche isolante (15) est attachée à la couche conductrice ou électrode (14).

6. Système de surveillance de courant de fuite d'appareillage de commutation selon l'une quelconque des revendications 4 et 5, dans lequel la couche isolante (15) est attachée à la pièce électriquement conductrice (12) à un potentiel de terre.

7. Système de surveillance de courant de fuite d'appareillage de commutation selon l'une quelconque des revendications 1 à 6, dans lequel chaque couche conductrice ou électrode parmi l'au moins une couche conductrice ou électrode (14) encercle le composant isolant parmi l'au moins un composant isolant (11) auquel elle est attachée ou intégrée.

8. Système de surveillance de courant de fuite d'appareillage de commutation selon l'une quelconque des revendications 1 à 7, dans lequel une couche conductrice ou électrode parmi l'au moins une couche conductrice ou électrode (14) est intégrée à l'intérieur d'une carte de circuit imprimé (19).

9. Système de surveillance de courant de fuite d'appareillage de commutation selon l'une quelconque des revendications 1 à 7, dans lequel une couche conductrice ou électrode parmi l'au moins une couche conductrice ou électrode (14) est une tôle métallique, ou une feuille collée, ou un fil.

10. Système de surveillance de courant de fuite d'appareillage de commutation selon l'une quelconque des revendications 1 à 9, dans lequel l'au moins un composant isolant (11) comprend un ou plusieurs éléments parmi : des traversées (29), des supports isolants, une isolation de fiches de contact (31), un boîtier isolant de transducteur de courant (33), un boîtier isolant de transducteurs de tension (32).

11. Système de surveillance de courant de fuite d'appareillage de commutation selon l'une quelconque des revendications 1 à 10, dans lequel l'au moins une connexion de données comprend au moins une connexion filaire (24.1), et dans lequel un circuit de mesure (40) intégré à l'intérieur de l'unité de surveillance de courant de fuite (22) comprend un shunt de faible impédance (41) et un voltmètre (43).

12. Système de surveillance de courant de fuite d'appareillage de commutation selon l'une quelconque des revendications 1 à 11, dans lequel l'au moins une connexion de données comprend au moins une connexion sans fil (24.2), et dans lequel une unité de mesure (44) est configurée pour fournir une ou plusieurs données de mesure relatives à l'au moins un courant de fuite sans fil à l'unité de surveillance de courant de fuite (22), et dans lequel l'unité de mesure est configurée pour être alimentée par le courant de fuite qu'elle mesure.
